Europäisches Patentamt

European Patent Office

Office européen des brevets

(11) Numéro de publication : **0 362 207 B1**

(12) **FASCICULE DE BREVET EUROPEEN**

(45) Date de publication du fascicule du brevet :
**13.05.92 Bulletin 92/20**

(21) Numéro de dépôt : **88902870.0**

(22) Date de dépôt : **21.03.88**

(86) Numéro de dépôt international :
**PCT/FR88/00149**

(87) Numéro de publication internationale :
**WO 88/07596 06.10.88 Gazette 88/22**

(51) Int. Cl.⁵ : **C23C 16/30, C23C 16/44**

(54) PROCEDE ET INSTALLATION POUR LE DEPOT CHIMIQUE DE REVETEMENTS ULTRADURS A TEMPERATURE MODEREE.

(30) Priorité : **27.03.87 FR 8704320**

(43) Date de publication de la demande :
**11.04.90 Bulletin 90/15**

(45) Mention de la délivrance du brevet :
**13.05.92 Bulletin 92/20**

(84) Etats contractants désignés :
**AT BE CH DE FR GB IT LI LU NL SE**

(56) Documents cités :
**EP-A- 0 117 542**
**FR-A- 2 084 428**
**FR-A- 2 323 773**
**Journal of Vacuum Science & Technology A,**
**vol. 4, No. 2, serial 2, Mar/Apr 1986, American**
**Vacuum Society, ( New York, US), D.G. Kim et**
**al.: " Effect of deposition variables on the**
**chemical vapor deposition of Tic using pro-**
**pane ", pages 219-221 seeabstract**

(73) Titulaire : **CHIMIE METAL**
**Parc Industriel Nord, Secteur PMI**
**F-77200 Torcy (FR)**

(72) Inventeur : **VANDENBULCKE, Lionel**
**131 bis, rue Demay**
**F-45650 St-Jean-le-Blanc (FR)**
Inventeur : **PITON, Jean-Paul**
**1, allée Carrefour la Rousse**
**F-45560 Saint-Denis-en-Val (FR)**
Inventeur : **LADOUCE, Béatrice**
**1, allée des Roseraies**
**Les Roseraies F-45100 Orléans (FR)**

(74) Mandataire : **Le Guen, Gérard et al**
**CABINET LAVOIX 2, place d'Estienne d'Orves**
**F-75441 Paris Cédex 09 (FR)**

## Description

La présente invention concerne un procédé et une installation de dépôt chimique à partir d'une phase gazeuse de revêtements réfractaires ayant une structure à grains très fins qui leur confèrent des duretés très supérieures aux duretés connues et habituellement obtenues pour les solides de compositions identiques.

On connait déjà un certain nombre de procédés de dépôts chimiques qui ont donné lieu à un développement industriel important, concernant des composés réfractaires, par exemple le carbure de titane, le nitrure de titane, l'alumine. Dans le cas du carbure de titane par exemple, le dépôt est généralemont réalisé à une température égale ou supérieure à 1000°C à partir de mélanges gazeux comprenant $TiCl_4$, $CH_4$ et $H_2$. Ces revêtements sont réalisés avec une vitesse de l'ordre de 1 à quelques microns par heure et la dureté du carbure de titane ainsi déposé est inférieure ou égale à environ 3200 kg.mm$^{-2}$. Dans ces conditions de température élevée, les caractéristiques mécaniques de certains substrats peuvent être dégradées et les pièces peuvent être déformées; c'est le cas des aciers par exemple. Même les outils de coupe en carbures cémentés, WC-Co et compositions dérivées, sont rendus plus cassants par cette température de dépôt, surtout s'ils sont utilisés en coupe interrompue.

Il est donc particulièrement intéressant de pouvoir abaisser cette température de dépôt. Avec les espèces chimiques habituellement utilisées, un tel abaissement conduit à des vitesses de dépôt négligeables ou nulles. Il est donc nécessaire d'utiliser des espèces chimiques plus réactives. Comme des vitesses de dépôt pas trop élevées, toujours de l'ordre de 1 à quelque microns par heure, sont nécessaires pour pouvoir réaliser des dépôts chimiques uniformes en épaisseur, composition et caractéristiques mécaniques sur de nombreux substrats dans de grands réacteurs, des espèces chimiques plus réactives employées à des températures plus faibles permettent de combiner ces deux impératifs.

A cet effet on a déjà proposé dans EP-A-0 117 542 d'effectuer le dépôt en utilisant à la place d'un halogénure de l'un des éléments à déposer, un sous-halogénure de cet élément. Ainsi on a proposé dans EP-A-0 117 542 de préparer dans un premier stade des sous-halogénures de titane en faisant passer un mélange d'hydrogène et de chlorure d'hydrogène sur un lit de particules de titane à une température de 500°C puis à ajouter de l'hydrogène et de l'azote et de faire passer le mélange sur le substrat chauffé à une température de 600°C. En variante l'azote est introduit dans le premier stade.

On a maintenant découvert un procédé qui permet d'obtenir des revêtements ayant des duretés très supérieures aux duretés connues des matériaux connus de même composition.

Ainsi la présente invention a pour objet un procédé d'obtention, par dépôt chimique à partir d'une phase gazeuse à température modérée, au plus égale à environ 850°C, de revêtements présentant une structure polynucléée à grains très fins qui leur confère une dureté améliorée et formés de composés réfractaires résultant de la combinaison d'un élément choisi parmi un premier groupe comprenant le titane, le zirconium, le hafnium, le vanadium, le niobium, le tantale, le chrome, le molybdène, le tungstène, le silicium et l'aluminium, avec un ou plusieurs éléments d'un second groupe comprenant le carbone, l'azote, l'oxygène et le bore. Dans ce procédé, on fait réagir en présence d'hydrogène un mélange gazeux contenant des sous-halogénures d'un élément du premier groupe avec un ou plusieurs composés contenant au moins un élément du deuxième groupe en présence d'un ou plusieurs substrats à revêtir portés a une température au plus égale à 850°C, les conditions de pression dans l'enceinte, de température, de débit gazeux total, de concentrations initiales en réactifs, et la stabilité des composés gazeux contenant un ou plusieurs éléments du deuxième groupe étant choisies de telles façons que l'élément du premier groupe soit libéré au moins en partie par dismutation de ses sous-halogénures en plus de leur réduction par l'hydrogène que le ou les éléments du second groupe soient apportées par des espèces gazeuses en forte concentration et que la vitesse d'écoulement des gaz devant les substrats soit d'au moins environ 50 cm/s afin que la sursaturation à l'interface gaz-dépôt soit élevée et conduise au dépôt d'un revêtement qui présente une structure polynucléée à grains très fins.

Dans un premier mode de réalisation de l'invention, cette dernière a pour objet un procédé d'obtention, par dépôt chimique à partir d'une phase gazeuse à température modérée, au plus égale à environ 850°C, de revêtements présentant une structure polynucléée à grains très fins qui leur confère une dureté améliorée, et formés de composés réfractaires résultant de la combinaison d'un élément choisi parmis un premier groupe comprenant le titane, le zirconium, le hafnium, le vanadium, le niobium, le tantale, le chrome, le molybdène, le tungstène et le silicium, avec un ou plusieurs éléments d'un second groupe comprenant le carbone, l'azote, l'oxygène et le bore, ce procédé étant caractérisé en ce que l'on forme un mélange d'halogénures d'un élément du premier groupe par réaction d'un halogène, d'un halogénure d'hydrogène ou d'un halogénure volatil de cet élément sur l'élément pur à l'état de solide divisé, dans des conditions de température $T_1$ et de pression favorisant une importante formation des sous-halogénures à l'état gazeux, puis on fait réagir en présence d'hydrogène le mélange gazeux ainsi formé avec un ou plusieurs composés contenant au moins un élément du deuxième groupe en présence d'un ou plusieurs substrats à revêtir portés à une température $T_2$ au plus égale à $T_1$ et comprise entre 450 et 850°C, les conditions de pression dans l'enceinte, de températures $T_1$ et $T_2$, de débit gazeux total, de concentrations initiales en réactifs, et la stabilité des composés gazeux contenant un ou plusieurs éléments du deuxième groupe étant choisies de telles façons que l'élément du premier groupe soit libéré au moins en partie par dismutation de ses sous-halogénures en plus de leur réduction par l'hydrogène, que le ou les éléments du second groupe soient apportés par des espèces gazeuses en forte concentration et que la vitesse d'écoulement des gaz devant les substrats soit d'au moins environ 50 cm/s afin que la sursaturation à l'interface gaz-dépot soit élevée et conduise au dépôt d'un revêtement qui présente une structure polynucléée à grains très fins.

Ainsi dans la présente invention on règle les conditions de pression totale, de température de dépôt notamment par rapport à la température de formation des sous-halogénures, de débit gazeux total et de concentrations initiales en réactifs de façon telle que la sursaturation de la phase gazeuse, à l'interface gaz-depôt, soit très élevée, tout en limitant une incorporation importante de chlore dans le revêtement (on peut rappeler que dans les dépôts physiques tels que l'évaporation sous vide d'un métal par exemple, la sursaturation s'exprime simplement comme étant le rapport entre la pression effective du métal dans l'enceinte d'évaporation et la pression qui serait en équilibre avec le métal solide à la température de dépôt. Dans les dépôts chimiques à partir de la phase gazeuse, on peut par extension définir la sursaturation comme l'excès de produit de réaction disponible dans la phase gazeuse à l'interface gaz-dépôt à la concentration qui serait en équilibre avec le solide déposé). Ces conditions du procédé permettant de réaliser une forte sursaturation à température modérée, inférieure ou égale à environ 850°C, conduisent au dépôt de revêtements qui présentent une structure polynucléée à grains très fins, de dimensions égales ou inférieures à environ 1000Å.

Le procédé de l'invention permet de réaliser des revêtements de dureté très élevée qui possèdent une structure fine, dureté de 25 à 100% supérieure à la dureté connue et habituellement reportée pour les revêtements de même composition obtenus par les procédés de dépôts chimiques classiques ou par frittage. Par exemple une dureté égale à environ 5000 kg/mm$^2$ est obtenue par le procédé de l'invention pour les revêtements de carbure de titane, à comparer avec la valeur habituelle d'environ 3200 kg/mm$^2$ qui existe dans les tables de microdureté.

Une variante de l'invention consiste à évaporer directement un sous-halogénure d'un élément du premier groupe pour le faire réagir, dans une enceinte à température et pression controlées, avec l'hydrogène et un ou plusieurs composés contenant au moins un élément du deuxième groupe en présence d'un ou plusieurs substrats à revêtir portés à une température au plus égale à environ 850°C et dans les conditions d'écoulement des gaz déjà indiquées.

Les revêtements déposés sont des composes réfractaires choisis essentiellement parmi les carbures, nitrures, oxydes et borures de titane, zirconium, hafnium, vanadium, niobium, tantale, chrome, molybdène, tungstène et silicium ainsi que l'alumine. Ce sont également les carbonitrures, oxycarbures, oxynitrures, borocarbures, boronitrures et oxyborures de titane, zirconium, hafnium, vanadium, niobium, tantale, chrome, molybdène, tungstène et silicium. Enfin les revêtements réalisés peuvent comporter plusieurs phases dont au moins une est un des composés réfractaires cités ci-dessus.

Le procédé est caractérisé entre autre par l'utilisation d'halogénures dont les sous-halogénures des éléments du premier groupe. Ces halogénures sont le plus souvent les chlorures et les fluorures.

Par ailleurs les composés gazeux contenant un élément du deuxième groupe sont, dans le cas du carbone, des hydrocarbures; le revêtement déposé contient alors au moins un carbure d'un élément du premier groupe. Lorsque ces composés gazeux sont l'azote, l'ammoniac, le revêtement déposé contient alors au moins un nitrure. Lorsque ces composés gazeux sont le gaz carbonique, la vapeur d'eau ou un oxyde d'azote, le revêtement déposé contient alors au moins un oxyde. Ces composés gazeux sont également les halogénures ou les hydrures de bore, auquel cas le revêtement déposé contient au moins un borure.

Parmi les revêtements en composés réfractaires mixtes, les carbonitrures sont particulièrement intéressants. Ils sont formés à partir de composés gazeux contenant à la fois le carbone et l'azote dans la même molécule mais aussi à partir de mélanges comprenant un hydrocarbure et l'azote ou l'ammoniac ou un mélange de ces deux derniers.

Le premier mode de réalisation précédemment défini trouve une application particulière à la formation d'un revêtement de carbure de titane. Dans ce cas, de préférence, on forme un mélange de chlorures de titane par réaction du chlore, du chlorure d'hydrogène ou du tétrachlorure de titane sur du titane pur solide à l'état divisé, dans des conditions de température $T_1$ et de pression favorisant une importante formation des sous-chlorures de titane à l'état gazeux, puis on fait réagir en présence d'hydrogène le mélange gazeux ainsi formé avec un hydrocarbure en présence d'un ou plusieurs substrats portés à une température $T_2$ au plus égale à $T_1$, et comprise entre 750 et 850°C, les conditions de pression dans l'enceinte, de températures $T_1$ et $T_2$, de débit gazeux total, de concentrations initiales en réactifs, et la stabilité de l'hydrocarbure étant choisie de telles façons que le titane soit libéré au moins en partie par dismutation de ses sous-chlorures en plus de leur réduction par l'hydrogène et que le carbone soit apporté par une ou plusieurs espèces gazeuses en forte concentration et que la vitesse d'écoulement des gaz devant les substrats soit d'au moins environ 50 cm/s afin que la sursaturation à l'interface gaz-dépôt soit élevée et conduise au depôt d'un revêtement qui présente une structure polynucléée à grains très fins.

L'hydrocarbure est alors de préférence le propane ou le butane et le débit d'hydrogène est de préférence au moins 100 fois supérieur au débit de chlore de chlorure d'hydrogène, ou de tétrachlorure de titane et le débit d'hydrocarbure au moins 3 fois supérieur au débit de l'un de ces derniers.

Les conditions particulières du procédé de l'invention conduisant à une sursaturation importante et au dépôt de revêtements extrêmement durs proviennent à la fois :

– de l'utilisation d'une température de formation des sous-halogénures au moins égale et le plus souvent supérieure à la température de dépôt;
– de l'introduction dans le réacteur d'un réactif comme le butane de telle façon que celui-ci ne passe jamais dans la zone haute température de production des sous-halogénures, de façon à éviter son craquage dans cette zone. Il est donc introduit directement dans la zone de dépôt du réacteur;
– de l'emploi d'une vitesse d'écoulement des gaz élevée devant la surface des substrats à revêtir, au moins égale et le plus souvent très supérieure à environ 50 centimètres par seconde.

La présente invention trouve également une application particulière à la formation d'un revêtement d'alumine. Dans ce cas, de préférence, on forme un mélange d'halogénures d'aluminium par réaction d'un halogène, d'un halogénure d'hydrogène où d'un halogénure d'aluminium volatil sur de l'aluminium métallique liquide ou sur un alliage d'aluminium à l'état de solide divisé ou l'activité de l'aluminium est élevée, dans des conditions de température et de pression favorisant une importante formation des sous-halogénures d'aluminium gazeux, puis on fait réagir en présence d'hydrogène le mélange gazeux ainsi formé avec au moins un composé contenant de l'oxygène en présence d'un ou plusieurs substrats à revêtir, les conditions de pression dans l'enceinte, de température, de débit gazeux total, de concentrations initiales en réactifs, et la stabilité du composé transportant l'oxygène étant choisies de telle façon que l'aluminium soit libéré au moins en partie par dismutation de ses sous-halogénures en plus de leur réduction par l'hydrogène et que la ou les espèces gazeuses apportant l'oxygène soient en forte concentration et que la vitesse d'écoulement des gaz devant les substrats soit d'au moins environ 50 cm/s afin que la sursaturation à l'interface gaz-dépôt soit élevée et conduise au dépôt d'un revêtement en alumine qui présente une structure polynucléée à grains très fins.

Dans ce cas le mélange d'halogénures d'aluminium est de préférence un mélange de chlorures.

La présente invention a également pour objet une installation pour la mise en oeuvre du procédé selon l'invention. Cette installation comprend :

– une enceinte comprenant une première partie et une deuxième partie qui communiquent entre elles et sont chauffées, par des moyens de chauffage extérieurs, respectivement à deux températures $T_1$ et $T_2$, telles que $T_2$ soit au plus égale à $T_1$ et de telle façon qu'il n'existe aucune zone à température inférieure à $T_2$ entre les deux parties de l'enceinte,
– une source d'halogène, d'halogénure d'hydrogène ou d'halogénure volatil d'un élément du premier groupe, qui communique avec la première partie de l'enceinte où se trouve disposé l'élément du premier groupe à l'état oxydation 0,
– une source d'hydrogène et une source de composes gazeux contenant au moins un élément du second groupe qui communiquent avec la deuxième partie de l'enceinte de telle façon que les composés gazeux de l'élément du second groupe ne s'écoulent jamais dans la première partie de l'enceinte,
– un ou plusieurs porte-substrats situés dans la deuxième partie de l'enceinte sur lesquels sont disposés les pièces à revêtir,
– un système de piégeage des produits corrosifs, de pompage et de régulation de pression, qui communique avec la deuxième partie de l'enceinte.

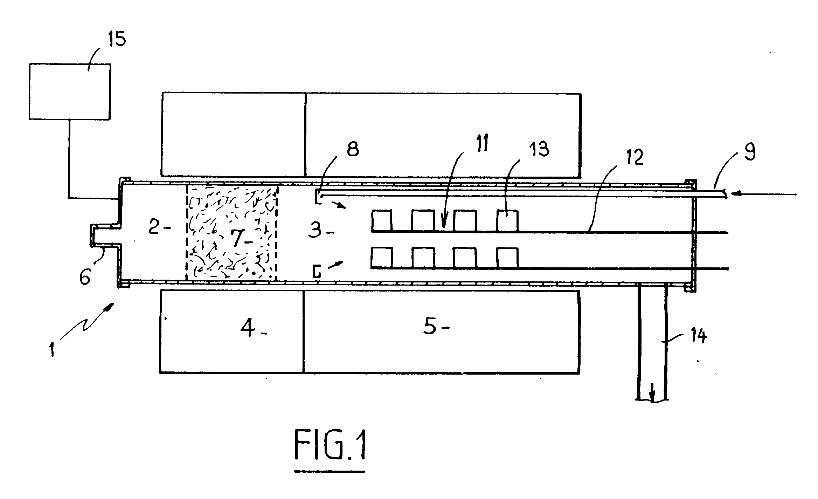

On a représenté sur la Figure 1 un schéma d'une installation selon l'invention.

Cette installation comprend une enceinte longitudinale 1 constituée d'une première partie 2 et d'une deuxième partie 3 dans le prolongement de la première.

La première partie 2 de l'enceinte est chauffée à une température $T_1$ par un four extérieur 4. La deuxième partie 3 de l'enceinte est chauffée à une température $T_2$ par un four extérieur contigü au four 4. $T_2$ est maintenue au plus égale à $T_1$.

L'installation comprend également un conduit central 6 débouchant dans la première partie 2 de l'enceinte 1, qui amène un gaz comprenant un halogène, un halogénure d'hydrogène ou un halogénure volatil de l'élément du premier groupe.

Dans la partie 2 est disposée l'élément 7 du premier groupe à l'état d'oxydation 0.

A l'entrée de la partie 3 débouche des orifices 8 d'une canalisation 9 traversant la partie 3 de l'enceinte. Par ces orifices est introduit un mélange gazeux comprenant de l'hydrogène et un composé gazeux contenant au moins un élément du second groupe.

Dans la zone centrale 11 de la partie 3 sont disposés des plateaux 12 portant des pièces 13 à revêtir.

Un conduit 14 relie la partie 3 de l'enceinte 1 à un système comprenant des piéges de produits volatils, une pompe, et un système de régulation de la pression (non représentés). Un manomètre 15 branché sur la partie 2 permet de mesurer la pression.

Les revêtements réalisés par le procédé de l'invention sont caractérisés par une structure à grains très fins qui est obtenue lorsque les conditions de dépôt conduisent à une sursaturation importante à l'interface gaz-dépôt. Une variante de l'installation permet à la fois d'augmenter cette sursaturation mais aussi de faciliter l'obtention de dépôts uniformes dans de grands réacteurs, ceci en augmentant la vitesse d'écoulement des gaz devant et autour des substrats sans changer le débit gazeux total qui entre dans l'enceinte de dépôt et qui est pompé à sa sortie. Cette variante de l'installation consiste à adjoindre un système de circulation des gaz par convection forcée, interne à la deuxième partie de l'enceinte, et constitué d'un ventilateur et d'une paroi entourant en partie les porte-substrats et les pièces à revêtir, de façon à assurer une recirculation de la phase gazeuse pour que la vitesse d'écoulement devant les surfaces à revêtir soit élevée, très supérieure à celle provoquée par le seul débit gazeux total qui entre dans l'enceinte et est pompé à la sortie.

L'invention sera mieux comprise à l'aide des exemples qui suivent. L'exemple 1 décrit une application du procédé de l'invention au dépôt du carbure de titane. L'exemple comparatif 1 décrit la mise en oeuvre et les résultats obtenus lorsqu'un dépôt chimique classique de carbure de titane est effectué à température élevée.

Exemple 1 :

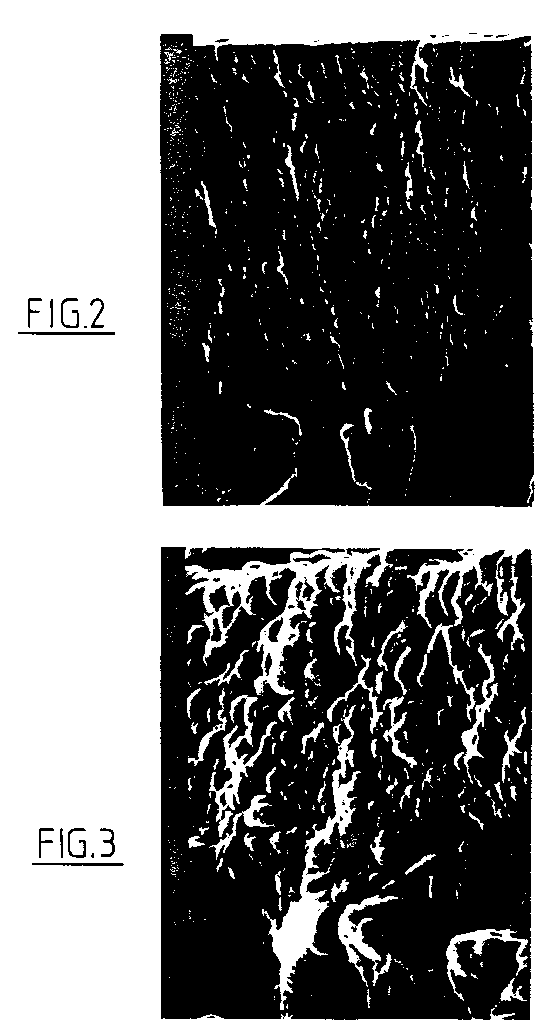

Un débit de 9 cm³/min. de TiCl$_4$ est entraîné par l'hydrogène et introduit dans le conduit 6 dans l'enceinte de traitement, dans la partie 2 contenant des copeaux de titane métallique portés, à 1050°C, de façon à former une quantité importante de sous-halogénures de titane. La phase gazeuse issue de cette réaction est mélangée à plus basse température, comprise entre 820 et 850°C, à 45 cm³/min. de C$_4$H$_{10}$ et à un débit d'hydrogène complémentaire tel que le débit total d'hydrogène introduit dans l'enceinte soit de 2100 cm³/min. Le dépôt est effectué sur des substrats 13 portés à une température comprise entre 800 et 820°C, la pression totale dans l'enceinte étant maintenue constante et égale à 5,4 kPa et la vitesse d'écoulement de la phase gazeuse devant les substrats étant de 115 cm/s. Au bout de 2 heures de dépôt un revêtement d'épaisseur environ 10 μm est obtenu, parfaitement adhérent sur des pièces en acier et en carbures cémentés. Les rayons X montrent qu'il s'agit d'un dépôt de carbure de titane bien cristallisé. La composition C/Ti mesurée est de 0,93 et la proportion de chlore incorporé est faible, inférieure ou égale à 0,3%. La microdureté Vickers du revetement mesurée sous une charge de 50g est de 5000 kg/mm². Ponctuellement des microduretés égales ou supérieures à 6000 kg/mm² ont été mesurées sur certains échantillons. La figure 2 montre la microstructure du dépôt observée au microscope électronique à balayage sur une fracture transversale d'un échantillon; on voit ainsi que la structure d'un dépôt réalisé suivant le procédé de l'invention comporte des grains très fins ayant une dimension moyenne inférieure à environ 1000 Å.

Exemple comparatif 1 :

Un débit de 20 à 80 cm³/min. de TiCl$_4$ est entraîné par de l'hydrogène et mélangé à un débit de 20 à 160 cm³/min. de CH$_4$ et à un débit complémentaire d'hydrogène tel que le débit total d'hydrogène soit de 1760 à 1960 cm³/min. Ce mélange gazeux est introduit dans l'enceinte de dépôt où les substrats à revêtir sont portés à la température de 1020°C, la pression totale dans l'enceinte étant maintenue constante pendant tout le traitement à une valeur comprise entre 2,7 et 10 kPa. Au bout de 4 heures de traitement, un dépôt de carbure de titane d'épaisseur comprise entre 4 et 8 μm est obtenue.

Quelles que soient les concentrations initiales en réactifs, la meilleure microdureté des couches de carbure de titane ainsi déposé à température égale ou supérieure à environ 1000°C, directement à partir de TiCl$_4$, atteint 3200 kg/mm². Il s'agit là de la microdureté du carbure de titane reportée dans les tables et que on retrouve quand du carbure de titane proche de la stoechiométrie est préparé par d'autres méthodes, par fusion en particulier.

Dans toutes ces préparations à température élevée, il faut noter que la taille des grains est beaucoup plus grande (entre 5 et 1000 fois suivant la méthode) que celle obtenue par le procédé de l'invention.. La figure 3 montre la microstructure d'un dépôt de très bonne qualité, de dureté 3200 kg/mm², réalisé à 1020°C dans les conditions de l'exemple comparatif 1.

L'invention a été plus particulièrement explicitée sur un exemple, le dépôt de carbure de titane, mais les mêmes avantages sont obtenus sur tous les systèmes et les composés cités précédemment qui font partie intégrante de l'invention.

**Revendications**

1. Procédé d'obtention, par dépôt chimique à partir d'une phase gazeuse à température modérée, au plus égale à environ 850°C, de revêtements présentant une structure polynucléée à grains très fins qui leur confère une dureté améliorée et formés de composés réfractaires résultant de la combinaison d'un élément choisi parmi un premier groupe comprenant le titane, le zirconium, le hafnium, le vanadium, le niobium, le tantale, le chrome, le molybdène, le tungstène, le silicium et l'aluminium, avec un ou plusieurs éléments d'un second groupe comprenant le carbone, l'azote, l'oxygène et le bore, dans lequel l'on fait réagir en présence d'hydrogène un mélange gazeux contenant des sous-halogénures d'un élément du premier groupe avec un ou plusieurs composés contenant au moins un élément du deuxième groupe en présence d'un ou plusieurs substrats à revêtir portés à une température au plus égale à 850°C, les conditions de pression dans l'enceinte, de température, de débit gazeux total, de concentrations initiales en réactifs, et la stabilité des composés gazeux contenant un ou plusieurs éléments du deuxième groupe étant choisies de telles façons que l'élément du premier groupe soit libéré au moins en partie par dismutation de ses sous-halogénures en plus de leur réduction par l'hydrogène, que le ou les éléments du second groupe soient apportées par des espèces gazeuses en forte concentration et que la vitesse d'écoulement des gaz devant les substrats soit d'au moins environ 50 cm/s, afin que la sursaturation à l'interface gaz-dépôt soit élevée.

2. Procédé selon la revendication 1 dans lequel les éléments du premier groupe sont choisis parmi le titane, le zirconium, le hafnium, le vanadium, le niobium, le tantale, le chrome, le molybdène, le tungstène et le silicium, caractérisé en ce que l'on forme un mélange d'halogénures d'un élément du premier groupe par réaction d'un halogène, d'un halogénure d'hydrogène ou d'un halogénure volatil de cet élément sur l'élément pur à l'état de solide divisé, dans des conditions de température $T_1$ et de pression favorisant une importante formation des sous-halogénures à l'état gazeux, puis on fait réagir en présence d'hydrogène le mélange gazeux ainsi formé avec un ou plusieurs composés contenant du moins un élément du deuxième groupe en présence d'un ou plusieurs substrats à revêtir portés à une température $T_2$ au plus égale à $T_1$ et comprise entre 450 et 850°C, les conditions de pression dans l'enceinte, de températures $T_1$ et $T_2$, de débit gazeux total, de concentrations initiales en réactifs, et la stabilité des composés gazeux contenant un ou plusieurs éléments du deuxième groupe étant choisies de telles façons que l'élément du premier groupe soit libéré au moins en partie par dismutation de ses sous-halogénures en plus de leur réduction par l'hydrogène, que le ou les éléments du second groupe soient apportés par des espèces gazeuses en forte concentration et que la vitesse d'écoulement des gaz devant les substrats soit d'au moins environ 50 cm/s, afin que la sursaturation à l'interface gaz-dépôt soit élevée.

3. Procédé selon la revendication 1 ou 2, caractérisé en ce que les composés réfractaires déposés en revêtement sont les carbures, les nitrures, les oxydes et les borures de titane, zirconium, hafnium, vanadium, niobium, tantale, chrome, molybdène, tungstène et silicium.

4. Procédé selon la revendication 1 ou 2, caractérisé en ce que les composés réfractaires déposés en revêtement sont les carbonitrures, oxycarbures, oxynitrures, borocarbures, boronitrures, oxyborures de titane, zirconium, hafnium, vanadium, niobium, tantale, chrome, molybdène, tungstène et silicium.

5. Procédé selon l'une quelconque des revendications précédentes, caractérisé en ce que les halogénures d'un élément du premier groupe sont les fluorures.

6. Procédé selon l'une quelconque des revendications 1 à 4, caractérisé en ce que les halogénures d'un élément du premier groupe sont les chlorures.

7. Procédé selon l'une quelconque des revendications 1 à 6, caractérisé en ce que les composés gazeux d'un élément du deuxième groupe sont des hydrocarbures, le revêtement déposé contenant alors au moins un carbure.

8. Procédé selon l'une quelconque des revendications 1 à 6, caractérisé en ce que les composés gazeux d'un élément du deuxième groupe sont l'azote ou l'ammoniac ou un mélange de ces deux composés, le revêtement déposé contenant alors au moins un nitrure.

9. Procédé selon l'une quelconque des revendications 1 à 6, caractérisé en ce que les composés gazeux amènent comme éléments du carbone et de l'azote et sont formés par des hydrocarbures et de l'azote ou de l'ammoniac ou un mélange de ces deux derniers, le revêtement déposé contenant alors au moins un carbonitrure.

10. Procédé selon l'une quelconque des revendications 1 à 6, caractérisé en ce qu'un composé gazeux contient à la fois du carbone et de l'azote, le revêtement déposé contenant alors au moins un carbonitrure.

11. Procédé selon l'une quelconque des revendications 1 à 6, caractérisé en ce que les composés gazeux d'un élément du deuxième groupe sont le gaz carbonique ou la vapeur d'eau ou un oxyde d'azote, le revêtement déposé contenant alors au moins un oxyde.

12. Procédé selon l'une quelconque des revendications 1 à 6, caractérisé en ce que les composés gazeux d'un élément du deuxième groupe sont les halogénures ou les hydrures de bore, le revêtement déposé contenant alors au moins un borure.

13. Procédé selon la revendication 1, d'obtention d'un revêtement en carbure de titane, caractérisé en ce que l'on forme un mélange de chlorures de titane par réaction du chlore, du chlorure d'hydrogène ou du tétrachlorure de titane sur du titane pur solide à l'état divisé, dans des conditions de température $T_1$ et de pression favorisant une importante formation des sous-chlorures de titane à l'état gazeux, puis on fait réagir en présence d'hydrogène le mélange gazeux ainsi formé avec un hydrocarbure en présence d'un ou plusieurs substrats portés à une température $T_2$ au plus égale à $T_1$, et comprise entre 750 et 850°C, les conditions de pression dans l'enceinte, de températures $T_1$ et $T_2$, de débit gazeux total, de concentrations initiales en réactifs, et la stabilité de l'hydrocarbure étant choisie de telles façons que le titane soit libéré au moins en partie par dismutation de ses sous-chlorures en plus de leur réduction par l'hydrogène et que le carbone soit apporté par une ou plusieurs espèces gazeuses en forte concentration et que la vitesse découlement des gaz devant les substrats soit d'au moins environ 50 cm/s afin que la sursaturation à l'interface gaz-dépôt soit élevée

14. Procédé selon la revendication 13, caractérisé en ce que l'hydrocarbure est le propane ou le butane.

15. Procédé selon la revendication 13 ou la revendication 14, caractérisé en ce que le débit d'hydrogène est au moins 100 fois supérieur au débit de chlore, de chlorure d'hydrogène, ou de tétrachlorure de titane et le débit d'hydrocarbure au moins 3 fois supérieur au débit de l'un de ces derniers.

16. Procédé selon la revendication 1, d'obtention de revêtements en alumine caractérisé en ce que l'on forme un mélange d'halogénures d'aluminium par réaction d'un halogène, d'un halogénure d'hydrogène ou d'un halogénure d'aluminium volatil sur de l'aluminium métallique liquide ou sur un alliage d'aluminium à l'état de solide divisé où l'activité de l'aluminium est élevée, dans des conditions de température et de pression favorisant une importante formation des sous-halogénures d'alumium gazeux, puis on fait réagir en présence d'hydrogène le mélange gazeux ainsi formé avec au moins un composé contenant de l'oxygène en présence d'un ou plusieurs substrats à revêtir, les conditions de pression dans l'enceinte, de température, de débit gazeux total, de concentrations initiales en réactifs, et la stabilité du composé contenant l'oxygène étant choisies de telle façon que l'aluminium soit libéré au moins en partie par dismutation de ses sous-halogénures en plus de leur réduction par l'hydrogène et que la ou les espèces gazeuses apportant l'oxygène soient en forte concentration et que la vitesse d'écoulement des gaz devant les substrats soit d'au moins environ 50 cm/s afin que la sursaturation à l'interface gaz-depôt soit élevé et conduise au dépôt de revêtements en alumine.

17. Procédé selon la revendication 16, caractérisé en ce que le mélange d'halogénures d'aluminium est un mélange de chlorures.

18. Procédé selon la revendication 16, caractérisé en ce qu'un composé contenant de l'oxygène est le gaz carbonique, la vapeur d'eau, ou un oxyde d'azote.

19. Installation pour la mise en oeuvre du procédé selon l'une quelconque des revendications 1 à 18, : comprenent :
– une enceinte (1) comprenant une première partie (2) et une deuxième partie (3) qui communiquent entre elles et sont chauffées, par des moyens de chauffage extérieurs, respectivement à deux températures $T_1$ et $T_2$, telles que $T_2$ soit au plus égale à $T_1$ et de telle façon qu'il n'existe aucune zone à température inférieure à $T_2$ entre les deux parties de l'enceinte,
– une source d'halogène, d'halogénure d'hydrogène ou d'halogénure volatil d'un élément du premier groupe, qui communique avec la première partie (2) de l'enceinte où se trouve disposé l'élément du premier groupe à l'état d'oxydation 0,
– une source d'hydrogène et une source de composés gazeux contenant au moins un élément du second groupe qui communiquent avec la deuxième partie (3) de l'enceinte de telle façon que les composés gazeux de l'élément du second groupe ne s'écoulent jamais dans la première partie (2) de l'enceinte,
– un ou plusieurs porte-substrats (12) situés dans la deuxième partie (3) de l'enceinte sur lesquels sont disposés les pièces à revêtir (13),
– un système de piégeage des produits corrosifs, de pompage et de régulation de pression, qui communique avec la deuxième partie (3) de l'enceinte.

20. Installation selon la revendication 18. caractérisé en ce qu'elle comprend un système de circulation des gaz par convection forcée, interne à la deuxième partie de l'enceinte, et constitué d'un ventilateur et d'une paroi entourant en partie les portes-substrats et les pièces à revêtir de façon à assurer une recirculation de la phase gazeuse pour que la vitesse d'écoulement devant les surfaces a revêtir soit élevée.

**Patentansprüche**

1. Verfahren zur Herstellung von Beschichtungen durch chemische Ablagerung aus der Gasphase bei mäßiger Temperatur, höchstens etwa 850°C, mit vielkerniger Struktur sehr feiner Körner mit verbesserter Festigkeit und aus hitzebeständigen Bestandteilen gebildet, die aus der Kombination eines Elements einer ersten Gruppe Titan, Zirkon, Hafnium, Vanadium, Niob, Tantal, Chrom, Molybdän, Wolfram, Silizium, Aluminium mit einem oder mehreren Elementen einer zweiten Gruppe Kohlenstoff, Stickstoff, Sauerstoff und Bor resultieren, durch Umsetzung, in Gegenwart von Wasserstoff, einer gasförmigen Mischung mit Gehalt an Unterhalogeniden eines Elements der ersten Gruppe mit einem oder mehreren Verbindungen mit Gehalt an mindestens einem Element der zweiten Gruppe in Gegenwart eines oder mehrerer Substrate zum Beschichten bei einer Temperatur von nicht höher als 850°C, wobei die Druckbedingungen, die Temperaturbedingungen, die Gesamtgasbilanz, die Anfangokonzentrationen an Reaktivstoffen und die Stabilität der gasförmigen Verbindungen, die eines oder mehrere Elemente der zweiten Gruppe enthalten, derart gewählt werden, daß die Elemente der ersten Gruppe mindestens teilweise durch Disproportionieren ihrer Unterhalogenide zusätzlich zu ihrer Reduktion durch Wasserstoff freigesetzt worden, daß das oder die Elemente der zweiten Gruppe in hoher Konzentration gasförmig herangeführt werden, und daß die Ablaufgeschwindigkeit der Gase über den Substraten mindestens etwa 50 cm/s beträgt, um die Übersättigung an der Grenzfläche Gas-Ablagerung zu erhöhen.

2. Verfahren nach Anspruch 1, wobei die Elemente der ersten Gruppe Titan, Zirkon, Hafnium, Vanadium, Niob, Tantal, Chrom, Molybdän, Wolfram und Silizium sind, dadurch gekennzeichnet, daß man eine Mischung von Halogeniden eines Elements der ersten Gruppe durch Umsetzung eines Halogenids, einem Halogenwasserstoff oder einem flüchtigen Halogen des Elements über dem reinen Element in festem zerteilten zustand bildet, wobei Bedingungen gewählt werden, daß die Temperatur $T_1$ und der Druck die Bildung von Unterhalogeniden in gasförmigen Zustand begünstigen; wobei dann in Gegenwart von Wasserstoff die gebildete gasförmige Mischung mit einer oder mehreren Verbindungen umgesetzt wird, die mindestens ein Element der zweiten Gruppe enthält, in Gegenwart von einer oder mehreren Substraten zum Beschichten bei einer Temperatur $T_2$, die höchstens $T_1$ ist, und zwischen 450° und 850°C liegt, wobei die Bedingungen des Drucks, der Temperatur $T_1$ und $T_2$, der Gesamtgasbilanz, der Anfangskonzentrationen der Reaktivstoffe und die Stabilität der gasförmigen Verbindungen mit Gehalt an einem oder mehreren Elementen der zweiten Geuppe derart gewählt werden, daß das Element der ersten Gruppe zumindest teilweise durch Disproportionierung seiner Unterhalogenide zusätzlich zur Reduktion durch Wasserstoff freigesetzt wird, wobei das oder die Elemente dar zweiten Gruppe gasförmig in starker Konzentration herangeführt werden, und daß die Geschwindigkeit des Abflusses der Gase über den Substraten mindestens 50 cm/s betragen soll, um die Übersättigung an der Grenzfläche Gas-Ablagerung zu erhöhen.

3. Verfahren nach Anspruch 1 oder 2, dadurch gekennzeichnet, daß die abzulagernden hitzebeständigen Verbindungen Karbide, Nitride, Oxide und(oder Borverbindungen von Titan, Zirkon Hafnium, Vanadium, Niob, Tantal, Chrom, Molybdän, Wolfram und-/oder Silizium sind.

4. Verfahren nach Anspruch 1 oder 2, dadurch gekennzeichnet, daß die abzulagernden hitzebeständigen Verbindungen die Kohlenstoffnitride, Oxikarbide, Oxinitride, Borkarbide, Bornitride, Oxiboride von Titan, Zirkon, Hafnium, Vanadium, Niob, Tantal, Chrom, Molybdän, Wolfram und(oder Silizium sind.

5. Verfahren nach einem der vorhergehenden Ansprüche, dadurch gekennzeichnet, daß die Halogenide eines Elements der ersten Gruppe die Fluoride sind.

6. Verfahren nach einem der vorhergehenden Ansprüche 1 bis 4, dadurch gekennzeichnet, daß die Halogenide eines Elements der ersten Gruppe die Chloride sind.

7. Verfahren nach einem der vorhergehenden Ansprüche 1 bis 6, dadurch gekennzeichnet, daß die gasförmigen Verbindungen eines Elements der zweiten Gruppe Kohlenwasserstoffe sind, wobei die abgelagerte Beschichtung zumindestens ein Karbid enthält.

8. Verfahren nach einem der Ansprüche 1 bis 6, dadurch gekennzeichnet, daß die gasförmigen Verbindungen eines Elements der zweiten Gruppe Stickstoff oder Ammoniak oder eine Mischung der beiden sind, wobei die abgelagerte Beschichtung mindestens ein Nitrid enthält.

9. Verfahren nach einem der Ansprüche 1 bis 6, dadurch gekennzeichnet, daß die gasförmigen Verbindungen als Elemente Kohlenstoff und Sticksttoff aufweisen und gebildet werden durch Kohlenwasserstoffe und Stickstoff oder Ammoniak oder eine Mischung der beiden, wobei die abgelagerte beschichtung mindestens ein Kohlenstoffnitrid enthält.

10. Verfahren nach einem der Ansprüche 1 bis 6, dadurch gekennzeichnet, daß eine gasförmige Verbindung Kohlenstoff und Stickstoff enthält, wobei die abgelagerte beschichtung mindestens ein Kohlenstoffnitrid enthält.

11. Verfahren nach einem der Ansprüche 1 bis 6, dadurch gekennzeichnet, daß die gasförmige Verbindung eines Elements der zweiten Gruppe Kohlenoxid oder Wasserdampf oder ein Stickstoffoxid ist, wobei die die abgelagerte Beschichtung mindestens ein Oxid enthält.

12. Verfahren nach einer der vorgehenden Ansprüche 1 bis 6, dadurch gekennzeichnet, daß die gasförmigen Verbindungen eines Elements der zweiten Gruppe die Halogenide oder die Hydride von Bor sind, wobei die abgelagerte Beschichtung mindestens ein Borid enthält.

13. Verfahren nach Anspruch 1 zum Erhalt einer Beschichtung von Titankarbid, dadurch gekennzeichnet, daß man eine Mischung von Chloriden von Titan durch Reaktion von Chlor, Chlorwasserstoff oder Tetrachlortitan auf festem zerteilten Titan herstellt, unter Temperaturbedingungen $T_1$ und Druckbedingungen, die die Bildung von Unterchloriden des Titan in gasförmigen zustand begünstigen, gefolgt von Umsetzung der gebildeten gasförmigen Mischung in Gegenwart von Wasserttoff mit einem Kohlenwasserstoff in Gegenwart von einem oder mehreren Substraten bei einer Temperatur $T_2$, die höchstens gleich $T_1$ ist, wobei sie zwischen 750 und 850°C liegt, wobei die Bedingungen des Drucks der Temperatur $T_1$ und $T_2$, die Gesamtgasbilanz, die Anfangskonzentrationen der reaktiven Stoffe und die Stabilität des Kohlenwasserstoffs derart gewählt werden, daß das titan mindestens teilweise durch Disproportionierung seiner Unterchloride zusätzlich zur Reduktion durch Wasserstoff freigesetzt wird, und daß der kohlenstoff in einer oder verschiedenen Gasformen in hoher Konzentration herangeführt wird, und daß die Ablaufgeschwindigkeit des Gases über dem Substrat mindestens etwa 50 cm/s beträgt, um die Übersättigung an der Grenzfläche Gas-Ablagerung erhöht wird.

14. Verfahren nach Anspruch 13, dadurch gekennzeichnet, daß der Kohlenwasserstoff Propan oder Butan ist.

15. Verfahren nach Anspruch 13 oder 14, dadurch gekennzeichnet, daß die Summe Wasserstoff mindestens hundertmal größer als die die Chlor, Chlorwasserstoff oder Tetrachlortitan ist, und daß die Summe Kohlenwasserstoff mindestens dreimal so groß wie die Summe der letzteren ist.

16. Verfahren nach Anspruch 1 zum Errhalt einer Aluminiumbeschichtung, dadurch gekennzeichnet, daß man eine Mischung bildet aus Aluminiumhalogeniden durch reaktion von Halogen, eines Halogenwasserstoffs oder eines flüchtigen Aluminiumalogenids über flüssigem metallischen Aluminium oder einer festen zerteilten Aluminiumlegierung mit erhöhter Aktivität des Aluminiums, wobei die Temperatur- und Druckbedingungen wesentliche Bildung des gasförmigen Aluminiumunterhalogenids begünstigt; worauf man in Gegenwart von Wasserstoff die gebildete gasförmige Mischung ansetzt mit mindestens einer Verbindung, die Sauerstoff enthält, in Gegenwart eines oder mehrerer Substrate zum Beschichten, wobei man die Bedingungen des Drucks, der Temperatur, der Gesamtgasbilanz, der Anfangskonzentrationen der Reaktivstoffe und die Stabilität der Verbindung, die den Sauerstoff enthält, derart wählt, daß das Aluminium mindestens teilweise durch Disproportionierung seiner Unterhalogenide zusätzlich zur Reduktion durch Wasserstoff freigesetzt wird, und daß das oder die Gase den Sauerstoff in hoher Konzentration heranführen, und daß die Geschwindigkeit des Ablaufs des Gases über den Substraten zumindest etwa 50 cm/s beträgt, so daß die Übersättigung der Grenzfläche Gas-Beschichtung erhöht wird und zur Ablagerung von Aluminiumbeschichtungen führt.

17. verfahren nach Anspruch 16, dadurch gekennzeichnet, daß die Mischung aus Halogeniden des Aluminiums eine Mischung von Chloriden ist.

18. Verfahren nach Anspruch 16, dadurch gekennzeichnet, daß eine Verbindung, die Sauerstoff enthält, Kohlenoxid, Wasserdampf oder ein Stickstoffoxid ist.

19. Vorrichtung zur Durchführung des Verfahrens nach einem der Ansprüche 1 bis 18, das folgende Zuteile aufweist:
    – ein Gehäuse (1) mit einem ersten Teil (2) und einem zweiten Teil (3), die miteinander verbunden sind, und von außen auf die Temperaturen $T_1$ bzw. $T_2$ aufgeheizt werden, derart, daß $T_2$ höchstens gleich $T_1$ ist, und daß keine Zone niederer Temperatur als $T_2$ zwischen den beiden Teilen des Gehäuses auftritt;
    – eine Quelle für Halogen, Halogenwasserstoff oder flüchtiges Halogenid eines Elements der ersten Gruppe, die mit dem ersten Teil (2) des Gehäuses verbunden ist, wo sich das Element der ersten Gruppe in der Oxidationsstufe 0 befindet;
    – eine Quelle für Wasserstoff und eine Quelle gasförmiger Verbindungen, die mindestens ein Element der zweiten Gruppe enthalten, die mit dem zweiten Teil (3) des Gehäuses derart verbunden ist, daß die gasförmigen Verbindungen des Elements der zweiten Gruppe sich nicht in den ersten Teil (2) des Gehäuses entleeren;
    – eine oder mehrere Trägersubstrate (12), die im zweiten Teil (3) des Gehäuses angeordnet sind, über die die zu beschichtenden Teile (13) angeordnet sind;
    – ein Abscheidesystem für korosive Produkte, zum Pumpen und zur Regulierung des Druckes, die mit dem zweiten Teil (3) des Gehäuses verbunden sind.

20. Vorrichtung nach Anspruch 18, dadurch gekennzeichnet, daß es ein Zirkulationssystem für Gas verstärkter Umwälzung innerhalb des zweiten Teils des Gehäuses aufweist und aus einem Ventilator und einem Schirm besteht, der teilweise die Trägersubstrate und die zu beschichtenden teile derart umschließt, daß eine Rückzirkulation der Gasphase stattfindet, um die Geschwindigkeit des Stromes vor (auf) den zu beschichtenden Oberflächen zu erhöhen.

## Claims

1. Process for obtaining, by chemical deposition starting from a gaseous phase at moderate temperature, of at most approximately 850°C, coatings having a very fine-grained polynuclear structure which gives them an improved hardness, and formed of refractory compounds resulting from the combination of an element selected from a first group comprising titanium, zirconium, hafnium, vanadium, niobium, tantalum, chromium, molybdenum, tungsten, silicon and aluminium, with one or more elements from a second group comprising carbon, nitrogen, oxygen and boron, wherein a gaseous mixture containing sub-halides of an element of the first group is reacted in the presence of hydrogen with one or more compounds containing at least one element of the second group in the presence of one or more substrates to be coated, brought to a temperature of at most 850°C., the conditions of pressure in the enclosure, of temperature, of total gas throughput, of initial concentrations of reagents, and the stability of the gaseous compounds containing one or more elements of the second group being selected such that the element of the first group is at least partially liberated by dismutation of its sub-halides in addition to their reduction by hydrogen, that the element or elements of the second group are supplied by a high concentration of gaseous substances, and that the flow velocity of the gases in front of the substrates is at least approximately 50 cm/sec., so that the supersaturation at the gas/deposit interface is high.

2. Process according to Claim 1, wherein the elements of the first group are selected from titanium, zirconium, hafnium, vanadium, niobium, tantalum, chromium, molybdenum, tungsten and silicon, characterised in that a mixture of halides of an element of the first group is formed by the reaction of a halogen, a hydrogen halide or a volatile halide of the said element with the pure element in the divided solid state, under conditions of temperature $T_1$ and pressure promoting considerable formation of the sub-halides in the gaseous state, then in the presence of hydrogen the gaseous mixture thus formed is reacted with one or more compounds containing at least one element of the second group in the presence of one or more substrates to be coated, brought to a temperature $T_2$ equal at most to $T_1$ and ranging between 450 and 850°C., the conditions of pressure in the enclosure, of temperatures $T_1$ and $T_2$, of total gas throughput, of initial concentrations of reagents, and the stability of the gaseous compounds containing one or more elements of the second group being selected such that the element of the first group is at least partially liberated by dismutation of its sub-halides in addition to their reduction by hydrogen, that the element or elements of the second group are supplied by a high concentration of gaseous substances and that the flow velocity of the gases in front of the substrates is at least approximately 50 cm/sec. so that the supersaturation at the gas/deposit interface is high.

3. Process according to Claim 1 or 2, characterised in that the refractory compounds deposited as a coating are carbides, nitrides, oxides and borides of titanium, zirconium, hafnium, vanadium, niobium, tantalum, chromium, molybdenum, tungsten and silicon.

4. Process according to Claim 1 or 2, characterised in that the refractory compounds deposited as a coating are carbonitrides, oxycarbides, oxynitrides, borocarbides, boronitrides, oxyborides of titanium, zirconium, hafnium, vanadium, niobium, tantalum, chromium, molybdenum, tungsten and silicon.

5. Process according to any one of the preceding Claims, characterised in that the halides of an element of the first group are fluorides.

6. Process according to any one of Claims 1 to 4, characterised in that the halides of an element of the first group are chlorides.

7. Process according to any one of Claims 1 to 6, characterised in that the gaseous compounds of an element of the second group are hydrocarbons, the coating deposited then containing at least one carbide.

8. Process according to any one of Claims 1 to 6, characterised in that the gaseous compounds of an element of the second group are nitrogen or ammonia or a mixture of these two compounds, the coating deposited then containing at least one nitride.

9. Process according to any one of Claims 1 to 6, characterised in that the gaseous compounds supply carbon and nitrogen as elements and are formed by hydrocarbons and nitrogen or ammonia or a mixture of the latter two, the coating deposited then containing at least one carbonitride.

10. Process according to any one of Claims 1 to 6, characterised in that a gaseous compound contains carbon and nitrogen at the same time, the coating deposited then containing at least one carbonitride.

11. Process according to any one of Claims 1 to 6, characterised in that the gaseous compounds of an element of the second group are carbon dioxide or water vapour or an oxide of nitrogen, the coating deposited then containing at least one oxide.

12. Process according to any one of Claims 1 to 6, characterised in that the gaseous compounds of an element of the second group are halides or hydrides of boron, the coating deposited then containing at least one boride.

13. Process according to Claim 1, for obtaining a titanium carbide coating, characterised in that a mixture of chlorides of titanium is formed by reaction of chlorine, hydrogen chloride or titanium tetrachloride with pure solid titanium in the divided state, under conditions of temperature $T_1$ and pressure promoting considerable formation of the sub-chlorides of titanium in the gaseous state, then in the presence of hydrogen the gaseous mixture thus formed is reacted with a hydrocarbon in the presence of one or more substrates brought to a temperature $T_2$ equal at most to $T_1$, and ranging between 750 and 850°C, the conditions of pressure in the enclosure, of temperatures $T_1$ and $T_2$, of total gas throughput, of initial concentrations of reagents, and the stability of the hydrocarbon being selected such that the titanium is at least partially liberated by dismutation of its sub-chlorides in addition to their reduction by hydrogen and that the carbon is supplied by a high concentration of one or more gaseous substances and that the flow velocity of the gases in front of the substrates is at least approximately 50 cm/sec. so that the supersaturation at the gas/deposit interface is high.

14. Process according to Claim 13, characterised in that the hydrocarbon is propane or butane.

15. Process according to Claim 13 or Claim 14, characterised in that the output of hydrogen is at least 100 times greater than the output of chlorine, hydrogen chloride or titanium tetrachloride, and the output of hydrocarbon is at least 3 times greater than the output of one of the latter.

16. Process according to Claim 1, for obtaining aluminium oxide coatings, characterised in that a mixture of aluminium halides is formed by reacting a halogen, a hydrogen halide or a volatile aluminium halide with liquid metallic aluminium or with an aluminium alloy in the solid divided state, where the activity of the aluminium is high, under conditions of temperature and pressure promoting considerable formation of the sub-halides of gaseous aluminium, then in the presence of hydrogen the gaseous mixture thus formed is reacted with at least one compound containing oxygen in the presence of one or more substrates to be coated, the conditions of pressure in the enclosure, of temperature, of total gas throughput, of initial concentrations of reagents, and the stability of the compound containing oxygen being selected such that the aluminium is at least partially liberated by dismutation of its sub-halides in addition to their reduction by hydrogen, and that there is a high concentration of the gaseous substance or substances supplying oxygen, and that the flow velocity of the gases in front of the substrates is at least approximately 50 cm/sec., so that the supersaturation at the gas/deposit interface is high and leads to the deposition of aluminium oxide coatings.

17. Process according to Claim 16, characterised in that the mixture of aluminium halides is a mixture of chlorides.

18. Process according to Claim 16, characterised in that a compound containing oxygen is carbon dioxide, water vapour or an oxide of nitrogen.

19. Installation for the implementation of the process according to any one of Claims 1 to 18, which comprises :
– an enclosure (1) comprising a first part (2) and a second part (3) which communicate with each other and are heated, by external heating means, respectively to two temperatures $T_1$ and $T_2$, such that $T_2$ is equal at most to $T_1$ and such that there is no temperature zone below $T_2$ between the two parts of the enclosure,
– a source of halogen, of hydrogen halide or of a volatile halide of an element of the first group, which communicates with the first part (2) of the enclosure where the element of the first group is arranged in the state of oxidation 0,

– a source of hydrogen and a source of gaseous compounds containing at least one element of the second group which communicate with the second part (3) of the enclosure such that the gaseous compounds of the element of the second group never flow into the first part (2) of the enclosure,
– one or more substrate-carriers (12) situated in the second part (3) of the enclosure on which the articles to be coated (13) are arranged,
– a system for trapping corrosive products, for pumping and for regulating pressure, which communicates with the second part (3) of the enclosure.

20. Installation according to Claim 18, characterised in that it comprises a system for circulating the gases by forced convection, within the second part of the enclosure, and consisting of a fan and of a wall partially surrounding the substrate-carriers and the articles to be coated, so as to ensure recirculation of the gaseous phase so that the flow velocity in front of the surfaces to be coated is high.

FIG.1

FIG.2

FIG.3